# EUROPÄISCHE PATENTSCHRIFT

(11) **EP 3 361 588 B1**
(45) Veröffentlichungstag und Bekanntmachung des Hinweises auf die Patenterteilung: **05.04.2023**
(21) Anmeldenummer: 17211023.1
(22) Anmeldetag: 29.12.2017
(51) Int. Cl.: H02H 1/04, H02H 9/02, H03K 17/082, H02H 3/24

(54) **VERFAHREN ZUM BETREIBEN EINES ELEKTRONISCHEN SCHUTZSCHALTERS UND ELEKTRONISCHER SCHUTZSCHALTER**
METHOD FOR OPERATING AN ELECTRONIC CIRCUIT BREAKER AND ELECTRONIC CIRCUIT BREAKER
PROCÉDÉ DE FONCTIONNEMENT D'UN DISJONCTEUR DE PROTECTION ÉLECTRONIQUE ET DISJONCTEUR DE PROTECTION ÉLECTRONIQUE

(30) Priorität: 09.02.2017 DE 102017202103
(43) Veröffentlichungstag der Anmeldung: 15.08.2018
(73) Patentinhaber: Ellenberger & Poensgen GmbH, 90518 Altdorf (DE)
(72) Erfinder: FISCHER, Erich, 90518 Altdorf (DE); VON DER LIECK, Guido, 90491 Nürnberg (DE)
(74) Vertreter: FDST Patentanwälte

(56) Entgegenhaltungen:
- EP-A2- 1 783 886
- AT-A4- 506 092
- DE-A1- 3 842 921

## Beschreibung

Die Erfindung betrifft ein Verfahren zum Betreiben eines elektronischen Schutzschalters mit einem zwischen einen Spannungseingang und einen Lastausgang geschalteten Halbleiterschalter, der beim Einschalten und/oder beim Zuschalten einer kapazitive Last in Abhängigkeit von der am Lastausgang erfassten Ausgangsspannung angesteuert wird. Die Erfindung betrifft weiterhin ein nach einem derartigen Verfahren betreibbaren elektronischen Schutzschalter.

Ein derartiger elektronischer Schutzschalter ist beispielsweise in der DE 203 02 275 U1 beschrieben. Der elektronische Schutzschalter weist einen Halbleiterschalter in Form eines MOSFETs (Metall-Oxid-Halbleiter-Feldeffekttransistor) auf, welcher zwischen einen Betriebsspannungsanschluss (Spannungseingang) und einen Lastanschluss in einen Strompfad geschaltet ist. Um in einem Gleichspannungsnetz eine zuverlässige Strombegrenzung zu erreichen, wird ein von einem Stromsensor im Strompfad erfasster Messwert einem Komparatoreingang einer Regeleinrichtung zugeführt. Bei Vorliegen eines Einschaltsignals und bei einem einen Referenzwert unterschreitenden Messwert steuert die Regeleinrichtung den Halbleiterschalter auf, während bei einem den Referenzwert überschreitenden Messwert die Regeleinrichtung den Leistungstransistor zusteuert und den über diesen fließenden Strom auf den Referenzwert begrenzt.

Aus der EP 1 186 086 B1 ist ein Stromverteilungssystem im Niedervoltbereich, insbesondere im 24V DC-Bereich, mit einer Anzahl von Stromkreisen mit jeweils einem elektronischen Schutzschalter als Kurzschluss- und/oder Überlastschutz bekannt. Die Stromkreise sind mittels eines getakteten Netzteils gemeinsam gespeist. Im Überlastfall erfolgt bei Überschreiten einer einstellbaren Stromschwelle, z. B. beim 1,1-Fachen des Nennstroms (I_{N}) eine Sperrung des elektronischen Schutzschalters nach Ablauf einer Verzögerungszeit, während im Kurzschlussfall zunächst eine Strombegrenzung und nach Überschreiten einer weiteren Stromschwelle (z. B. 2 x I_{N}) eine Sperrung des Schutzschalters nach Ablauf einer bestimmten Abschaltzeit erfolgt.

Aus der EP 1 150 410 A2 ist ein mittels eines Mikroprozessors über einen Auslösekreis angesteuerter elektronischer Schutzschalter bekannt, welcher die Energieversorgung zu einer Last mit einer Zeitverzögerung unterbricht. Zuvor oder zeitgleich erfolgt eine partielle Unterbrechung des Schutzschalters.

Eine partielle Unterbrechung eines elektronischen Schutzschalters mit mehreren Schaltblöcken, welche jeweils einen elektronischen Schalter in Form eines MOSFET und einen diesen über einen gemeinsamen Mikroprozessor steuernden Komparator aufweisen, ist auch aus der EP 1 294 069 B1 bekannt. Im Falle eines Überstroms wird die Energieversorgung zur Last nach einer Zeitverzögerung unterbrochen, die auf eine partielle Untersagung des wenigstens einen Schalters folgt.

Zum Schalten insbesondere kapazitiver Lasten und/oder zu deren Schutz gegen Überstrom und Kurzschluss wird der Halbleiterschalter des elektronischen Schutzschalters als Konstantstromquelle zum Laden der Kapazität genutzt. Der Halbleiterschalter und insbesondere ein hierbei eingesetzter MOSFET muss in der Lage sein, während des Schaltens beziehungsweise im Zuge des Ladens der Kapazität die Verlustleistung in Folge des Einschaltstroms tragen zu können. Aufgrund dieser Situation werden elektronische Schutzschalter, insbesondere solche mit aktiver Strombegrenzung, üblicherweise mit einem überdimensionierten Halbleiterschalter (MOSFET) ausgelegt, um dieser Verlustleistung ausreichend Rechnung zu tragen. Eine derartige Dimensionierung des eingesetzten Halbleiterschalters führt jedoch zu einem erhöhten Kostenaufwand und einem entsprechend gro-ßen Raumbedarf innerhalb der Schaltung des elektronischen Schutzschalters. Eine kapazitive Last ist zum Einschalt- oder Zuschaltzeitpunkt ungeladen und kann somit eine Vielzahl an Elektronen aufnehmen. Dadurch ist der Widerstand der Kapazität beim Einschalten sehr gering wodurch ein hoher Stromfluss auftritt, welcher vergleichbar mit einem Kurzschlussstrom ist. Durch die starke Strombelastung kommt es zu einem Einbruch der Ausgangsspannung des Schutzschalters. Der Schutzschalter weist typischerweise eine einstellbare Stromschwelle für den Überlastfall auf, beispielsweise das 1,25- oder 1,5-fache des Nennstroms, auf welche der Stromfluss beim Einschalten oder bei einem Hinzuschalten der kapazitiven Last begrenzt wird. Dies kann dazu führen, dass die Ladezeit der kapazitiven Last länger ist, als die Abschaltzeit (Auslösezeit) des Schutzschalters bei Kurzschluss. Dadurch ist es möglich, dass der Schutzschalter auslöst, wodurch die Last nicht zuverlässig eingeschaltet werden kann. Dies führt insbesondere in einem Stromkreis mit mehreren Lasten dazu, dass im Falle eines Einbruchs der Ausgangsspannung andere angeschlossene Lasten ausfallen und/oder in einen passivierten Zustand übergehen.

Die DE 10 2014 012 828 A1 beschreibt einen elektronischen Schutzschalter mit einer dynamischen Strombegrenzung während eines Ladevorgangs einer kapazitiven Last. Der bekannte Schutzschalter erfasst einen Last- oder Halbleiterstrom sowie eine über einen Halbleiterschalter (MOSFET) abfallende Spannung (Source-Drain-Spannung), wobei hieraus ein Ansteuersignal für den Halbleiterschalter erzeugt wird. Die Leistung des Halbleiterschalters wird hierbei anhand des Ansteuersignals auf einen maximalen Leistungswert eingestellt.

In der DE 10 2015 219 545 B3 ist ein elektronischer Schutzschalter mit einem Halbleiterschalter und mit einer damit gekoppelten Steuereinheit beschrieben, welche im Überlast- oder Kurzschlussfall oder bei einem Einschalten auf eine kapazitive Last zunächst eine Strombegrenzung bewirkt. Hierzu wird ein Sollwert des Ausgangsstroms unter Berücksichtigung eines maximalen Leistungsverlustes des Halbleiterschalters eingestellt.

Die EP 1 150 410 A2 offenbart einen elektronischen Schutzschalter, bei welchem ein Halbleiterschalter und ein Stromsensor in Reihe zu einer angeschlossenen Last geschaltet sind. Der Schutzschalter weist weiterhin eine Steuereinheit auf, in welcher drei Stromschwellwerte hinterlegt sind, wobei der Halbleiterschalter in Abhängigkeit von Schwellwertvergleichen der hinterlegten Stromschwellwerte mit einem durch den Stromsensor erfassten Ausgangsstrom angesteuert wird.

Die EP 1 186 086 B1 beschreibt ein Stromverteilungssystem mit einer Anzahl von Stromkreisen mit jeweils einem Halbleiterschalter aufweisenden Schutzschalter als Kurzschluss- oder Überlastschutz. Der oder jede Schutzschalter umfasst hierbei eine einstellbare Strombegrenzung, wobei im Überlastfall bei einem Überschreiten einer ersten einstellbaren Stromschwelle eine Sperrung des Halbleiterschalters nach Ablauf einer ersten einstellbaren Abschaltzeit erfolgt, und wobei im Kurzschlussfall eine Begrenzung des Stromes durch den Halbleiterschalter auf eine zweite einstellbare Stromschwelle und eine Sperrung des Halbleiterschalters nach Ablauf einer zweiten Abschaltzeit erfolgt.

In der DE 203 02 275 U1 beschreibt einen elektronischen Schutzschalter mit einem Halbleiterschalter und mit einem hierzu in Reihe geschalteten Stromsensor sowie mit einer Regeleinrichtung zur strombegrenzenden Ansteuerung des Halbleiterschalters in Abhängigkeit eines mittels des Stromsensors erfassten Messwerts. Der erfasste Messwert wird zusammen mit einem Referenzwert einem Komparator der Regeleinrichtung zugeführt, wobei bei einem Überschreiten des Referenzwertes durch den Messwert der Halbleiterschalter durch die Regeleinrichtung zugesteuert und somit der fließende Strom auf den Referenzwert begrenzt wird.

Die DE 10 2012 103 551 B4 offenbart einen elektronischen Schutzschalter mit einer mittels einer Steuereinheit steuerbaren Schalteinrichtung und mit einem Stromsensor sowie mit einem Spannungssensor. Die Steuereinheit öffnet hierbei die Schalteinrichtung, wenn anhand eines durch den Stromsensor erfassten Ausgangsstroms ein Kurzschluss festgestellt wird. Die Steuereinheit schließt die Schalteinrichtung anschließend wieder, wenn eine Differenz zwischen einer nach dem letzten Öffnen der Schalteinrichtung mittels des Spannungssensors erfassten Ausgangsspannung und einer vor dem letzten Öffnen der Schalteinrichtung mittels des Spannungssensors erfassten Ausgangsspannung einen hinterlegten Spannungsschwellwert übersteigt.

Die AT 506 092 A4 beschreibt eine elektrische Anlage mit zumindest einem Verbraucher, welcher mittels einer Schutzeinrichtung abgesichert ist, wobei ein Auslöseparameter der Schutzeinrichtung einstellbar ist. Gemäß der AT 506 092 A4 ist eine Steuereinheit vorgesehen, welcher ein Strommesswert des von dem zumindest einen Verbraucher aufgenommenen Stromes zugeführt ist, wobei die Steuereinheit in Abhängigkeit des Verlaufs des Strom messwertes einen Grenzwert generiert, welcher der Schutzeinrichtung zur Einstellung eines Auslöseparameters vorgegeben ist.

In der EP 1 783 886 A2 ist eine Lastantriebsvorrichtung zum Steuern eines Antriebs und eines Stopps einer Last durch Ein/Aus-Schalten eines Halbleiterbauelements unter der Steuerung einer Antriebsschaltung beschrieben. Die Vorrichtung weist eine Überstromerfassungseinheit auf, die mit einer vorgeschriebenen Beurteilungsspannung eine Zwischenelektrodenspannung vergleicht, die erzeugt wird, wenn ein Strom zwischen einer ersten Elektrode und einer zweiten Elektrode des Halbleiterbauelements fließt, und beurteilt, dass ein Überstrom durch die Halbleitervorrichtung fließt, wenn die Zwischenelektrodenspannung höher ist als die Beurteilungsspannung. Die Vorrichtung weist weiterhin eine Diagnoseeinheit auf, die eine Diagnose durchführt, ob die Überstromerfassungseinheit in einem Zustand, in dem sich die Halbleitervorrichtung im Ein-Zustand befindet, normal arbeitet. Wenn die Diagnoseeinheit feststellt, dass die Überstromerfassungseinheit nicht normal arbeitet, gibt die Diagnoseeinheit ein Befehlssignal zum Ausschalten der Halbleitervorrichtung an die Treiberschaltung aus.

Die DE 38 42 921 A1 offenbart eine Schaltungsanordnung zur Stromüberwachung elektrischer Verbraucher, die in ihrer Stromzuführung ein Strommeßglied aufweist, dessen stromabhängige Meßspannung einer Vergleichs- und Auswerteschaltung zugeführt wird. Die Vergleichsschaltung besteht hierbei aus einem Komparator, auf dessen einem Eingang das stromabhängig veränderbare Potential des Strommeßgliedes gelegt ist und dessen anderer Eingang an einer Referenzwertschaltung angeschlossen ist. An dem Ausgang der Vergleichsschaltung tritt jeweils beim Einschalten eines zu überwachenden Verbrauchers ein diesem zugeordneter Grenzwert auf, so daß die Abweichung des augenblicklichen Verbraucherstromes von diesem Grenzwert um einen vorgegebenen Betrag der Komparator eine Signaländerung an die Auswerteschaltung zur Erzeugung eines Störsignals abgibt. Die Auswerteschaltung umfaßt einen Mikrorechner, der über Steuerausgänge die Schaltmittel für das Ein- und Ausschalten der zu überwachenden Verbraucher steuert, sowie ferner über eine Busleitung mit dem Eingang eines Digital-Analog-Wandlers der Referenzwertschaltung verbunden ist, und wobei mit jedem Einschalten des Verbrauchers, der ihm zugeordnete Grenzwert zeitlich abgestuft gesteuert vom Mikrorechner über die Busleitung und den Digital-AnalogWandler auf den Komparator gelangt.

Der Erfindung liegt die Aufgabe zugrunde, ein besonders geeignetes Verfahren zum Betreiben eines elektronischen Schutzschalters anzugeben. Der Erfindung liegt weiterhin die Aufgabe zugrunde, ein nach einem derartigen Verfahren betreibbaren elektronischen Schutzschalter anzugeben.

Hinsichtlich des Verfahrens wird die Aufgabe mit den Merkmalen des Anspruchs 1 und hinsichtlich des Schutzschalters mit den Merkmalen des Anspruchs 6 erfindungsgemäß gelöst. Vorteilhafte Ausgestaltungen und Weiterbildungen sind Gegenstand der jeweiligen Unteransprüche.

Das erfindungsgemäße Verfahren ist zum Betreiben eines elektronischen Schutzschalters mit einem zwischen einen Spannungseingang und einen Lastausgang geschalteten Halbleiterschalter geeignet und eingerichtet. Der beispielsweise als MOSFET ausgeführte Halbleiterschalter wird bei einem Einschalten und/oder beim Zuschalten einer kapazitiven Last in Abhängigkeit einer am Lastausgang erfassten Ausgangsspannung beziehungsweise Lastspannung angesteuert.

Verfahrensgemäß ist vorgesehen, dass die erfasste Ausgangsspannung mit einem hinterlegten Spannungsschwellwert verglichen wird. Der Spannungsschwellwert wird beispielsweise anhand einer Differenz einer erfassten Betriebsspannung zwischen dem Spannungseingang und dem Lastausgang und einem fixen Schwellwert bestimmt. In einer beispielhaften Ausführungsform ist der fixe Schwellwert auf 12V festgelegt. Wird hierbei eine Betriebsspannung von beispielsweise 25V erfasst, so wird der Spannungsschwellwert auf 25V - 12V = 13V festgelegt und für den Schwellwertvergleich mit der Ausgangsspannung hinterlegt.

Wird der Spannungsschwellwert von der Ausgangsspannung erreicht oder unterschritten, so wird ein Stromgrenzwert von einem Nennwert auf einen gegenüber diesem erhöhten ersten Stufenwert eingestellt. Ein von dem Halbleiterschalter geführter Laststrom (Ausgangsstrom) oder Halbleiterstrom ist hierbei während des Betriebs auf den jeweiligen Stromgrenzwert begrenzt.

Vorzugsweise entspricht der Nennwert im Wesentlichen einem Nennstrom des Schutzschalters beziehungsweise Halbleiterschalters, also derjenigen elektrischen Stromstärke, welche der Schalter bei einer Versorgung mit der Nennspannung (Bemessungsspannung) im Normalbetrieb zur Abgabe seiner Nennleistung aufnimmt. Unter einem Nennstrom wird somit insbesondere der Bemessungsstrom (DIN-EN 60934) zu verstehen, insbesondere ein festgelegter Strom, welcher dauerhaft über den Schutzschalter fließen darf.

Verfahrensgemäß wird der Stromgrenzwert anschließend von dem ersten Stufenwert stufenweise auf den ursprünglichen Nennwert reduziert. Der Halbleiterschalter wird geöffnet, also sperrend beziehungsweise elektrisch nicht-leitend geschaltet, wenn die Ausgangsspannung während einer Auslösezeitdauer nach der stufenweisen Reduzierung des Stromgrenzwerts den Spannungsschwellwert nicht erreicht. Dies bedeutet, dass der Schutzschalter ausgelöst wird. Wird der Spannungsschwellwert überschritten, so ist die Last- oder Ausgangsspannung in einem gewünschten Spannungsbereich. Mit anderen Worten löst der Schutzschalter lediglich aus, wenn der Spannungsschwellwert nicht erreicht wird. Dadurch ist ein besonders geeignetes Verfahren zum Betreiben eines elektronischen Schutzschalters realisiert.

Das erfindungsgemäße Verfahren reagiert somit auf den Anschluss einer kapazitiven Last und/oder bei einem Einschalten auf eine kapazitive Last mit einer zeitweisen Erhöhung der Strombegrenzung beziehungsweise des Stromgrenzwertes. Die durch den Stromgrenzwert vorgegebene Strombegrenzung wird anschließend stufenförmig (schrittweise) reduziert, bis sie den ursprünglichen Nennwert erreicht. Der ursprüngliche Nennwert wird anschließend für die Auslösezeitdauer beibehalten. Die etwa stufenförmige Strombegrenzung bildet somit im Wesentlichen eine Hüllkurve über den eigentlichen Stromverlauf beim Einschalten oder Hinzuschalten der kapazitiven Last ab. Ist die Ausgangsspannung während der Auslösezeitdauer weiterhin oder erneut unterhalb (oder gleich) dem Spannungsschwellwert, so wird ein Fehlerfall, beispielsweise ein Kurzschluss, erkannt, woraufhin der Schutzschalter auslöst und somit den Strompfad zwischen Spannungseingang und Lastausgang unterbricht.

Erfindungsgemäß ist mindestens ein zweiter Stufenwert zwischen dem ersten Stufenwert und dem Nennwert vorgesehen, auf welchen der Stromgrenzwert bei der stufenweisen Reduzierung eingestellt wird. Mit anderen Worten weist die stufenweise Strombegrenzung mindestens zwei Stufen auf. Vorzugsweise sind hierbei zwischen fünf und 25 Stufen vorgesehen. Dadurch ist eine besonders genaue Hüllkurve für den eigentlichen Stromverlauf beim Einschalten oder Hinzuschalten der kapazitiven Last realisiert. In einer geeigneten Weiterbildungsform sind die Anzahl der Stufen sowie die jeweils zugeordneten Stufenwerte vorzugsweise von einem Benutzer einstellbar.

In einer geeigneten Ausführung wird der Stromgrenzwert nach einer jeweiligen Stufenzeitdauer auf den nächstfolgenden Wert reduziert. Mit anderen Worten weist jeder Stufenwert eine zugeordnete Stufenzeitdauer auf, wobei nach Ablauf der jeweiligen Stufenzeitdauer auf den nächstfolgenden Stufenwert oder den Nennwert umgeschaltet wird. Dadurch ist ein einfaches und zweckmäßiges Umschalten zwischen den Stufenwerten während der stufenweisen Reduzierung der Strombegrenzung ermöglicht.

In einer zweckmäßigen Ausgestaltung weisen die einzelnen Stufenwerte gleichlange Stufenzeitdauern auf. Dies bedeutet, dass jedem Stufenwert während der stufenweisen Reduzierung der Strombegrenzung die gleiche Stufenzeitdauer zugeordnet ist. Dadurch ist eine geeignete Dimensionierung der Stufenzeitdauern realisiert.

Ein zusätzlicher oder weiterer Aspekt des Verfahrens sieht vor, dass die Auslösezeitdauer gleich der Summe der einzelnen Stufenzeitdauern ist. Dies bedeutet, dass die Zeitdauer für die stufenweise Strombegrenzung im Wesentlichen gleich der Auslösezeitdauer ist.

In einer geeigneten Ausgestaltungsform sind die Zeitdauer für die stufenweise Strombegrenzung und die Auslösezeitdauer anhand einer Kurzschluss-Detektionszeit des elektronischen Schutzschalters dimensioniert. Die Kurzschluss-Detektionszeit, also die Detektions- beziehungsweise Abschaltzeit im Falle eines Kurzschlusses zur elektronischen Abschaltung beziehungsweise Öffnung des Halbleiterschalters, ist in der Regel abhängig von dem Nennwert des Laststroms beziehungsweise von dem Nennstrom. Beträgt die Kurzschluss-Detektionszeit beispielsweise 100 ms (Millisekunden), so weist die stufenweise Strombegrenzung und die Auslösezeitdauer zum Beispiel jeweils eine Zeitdauer von 50 ms auf.

In einer geeigneten Ausbildung wird der Stromgrenzwert auf einen ersten Stufenwert erhöht, welcher gleich einem Vielfachen, insbesondere einem Dreifachen, des Nennwerts ist. Dadurch ist eine besonders vorteilhafte Dimensionierung des ersten Stufenwerts realisiert.

Der erfindungsgemäße elektronische Schutzschalter umfasst einen Halbleiterschalter, welcher zwischen einem Spannungseingang und einem Lastausgang geschaltet sowie steuerseitig an einen Controller (Steuereinheit) geführt ist.

Der Controller ist hierbei allgemein - programm- und/oder schaltungstechnisch - zur Durchführung des vorstehend beschriebenen erfindungsgemäßen Verfahrens eingerichtet. Der Controller ist somit insbesondere dazu eingerichtet einen Schwellwertvergleich der Ausgangsspannung durchzuführen und den Last- oder Halbleiterstrom mittels einer Strombegrenzung zu begrenzen sowie die Strombegrenzung von einem Nennwert auf einen ersten Stufenwert zu erhöhen und anschließend stufenweise zu reduzieren.

Der Controller ist zumindest im Kern durch einen Mikrocontroller mit einem Prozessor und einem Datenspeicher gebildet, in dem die Funktionalität zur Durchführung des erfindungsgemäßen Verfahrens in Form einer Betriebssoftware (Firmware) programmtechnisch implementiert ist, so dass das Verfahren - gegebenenfalls in Interaktion mit einem Benutzer - bei Ausführung der Betriebssoftware in dem Mikrocontroller automatisch durchgeführt wird.

Der Controller ist in einer möglichen Ausführungsform im Rahmen der Erfindung alternativ aber auch durch programmierbare elektronische Bauteile, zum Beispiel einen anwendungsspezifischen integrierten Schaltkreis (ASIC) gebildet, in dem die Funktionalität zur Durchführung des erfindungsgemäßen Verfahrens mit schaltungstechnischen Mitteln implementiert ist.

Nachfolgend sind Ausführungsbeispiele der Erfindung anhand einer Zeichnung näher erläutert. Darin zeigen:
- Fig. 1: in einem schematischen Blockschaltbild einen elektronischen Schutzschalter mit einem im Pluspfad einer Stromsteuerung angeordneten Halbleiterschalter sowie mit einem diesen ansteuernden Controller,
- Fig. 2: in einem Flussdiagramm den Verfahrensverlauf des Betriebsverfahrens des elektronischen Schutzschalters bei einem Einschalten oder beim Hinzuschalten einer kapazitiven Last,
- Fig. 3: in einem Strom-Zeit-Diagramm den Verlauf eines Ladestroms der kapazitiven Last während einer stufenförmigen Strombegrenzung des Schutzschalters,
- Fig. 4: in einem Strom-/Spannungs-Zeit-Diagramm den Verlauf einer Ausgangsspannung und eines durch die Strombegrenzung begrenzten Laststromes des Schutzschalters bei einem andauernden Überlaststrom,
- Fig. 5: in einem Strom-/Spannungs-Zeit-Diagramm den Verlauf der Ausgangsspannung und des Laststromes des Schutzschalters während eines Einschaltvorgangs der kapazitiven Last bei welchem der Schutzschalter nicht ausgelöst wird, und
- Fig. 6: in einem Strom-/Spannungs-Zeit-Diagramm den Verlauf der Ausgangsspannung und des Laststromes des Schutzschalters während eines Einschaltvorgangs der kapazitiven Last bei welchem der Schutzschalter ausgelöst wird.

Einander entsprechende Teile und Größen sind in allen Figuren stets mit den gleichen Bezugszeichen versehen.

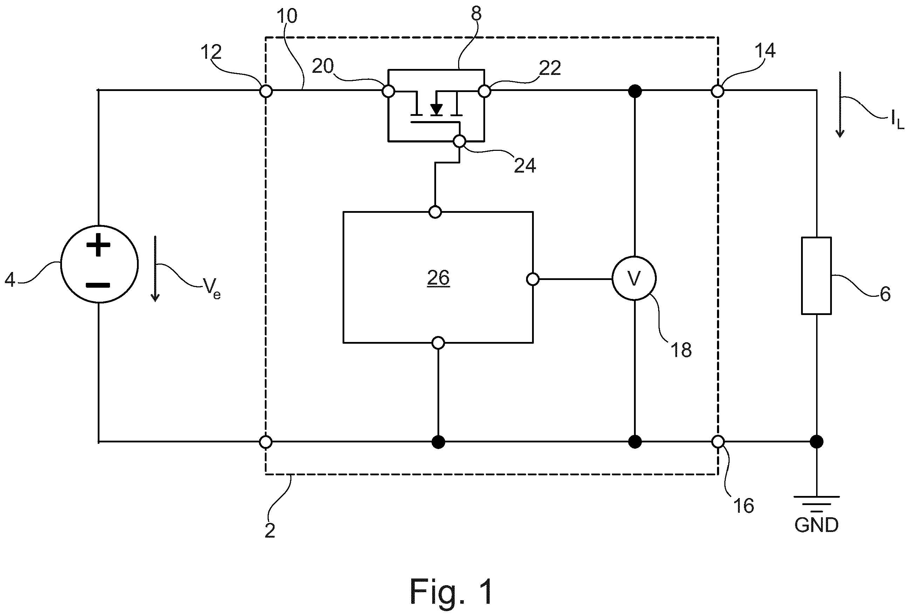

Der in Fig. 1 schematisch dargestellte elektronische Schutzschalter 2 ist in einen Stromkreis zwischen einer Strom- oder Spannungsquelle eines Netzteils 4 und einer kapazitiven Last 6 verschaltet. Der Schutzschalter 2 umfasst einen Leistungstransistor oder Halbleiterschalter 8 in Form eines MOSFETs, welcher in einem Strompfad 10, nämlich dem Pluspfad des Schutzschalters 2, geschaltet ist.

Der Strompfad 10 erstreckt sich zwischen einem Betriebsspannungsanschluss oder Spannungseingang 12 und einem positiven Lastanschluss oder Lastausgang 14. An den Lastausgang 14 wird der Pluspol der zu schaltenden Last 6 angeschlossen, während ein Minuspol an einen entsprechenden negativen Lastanschluss 16 des Schutzschalters 2 anzuschließen ist. Dieser Lastanschluss 16 ist im dargestellten Ausführungsbeispiel gegen Ground GND geführt.

Die von der Strom- oder Spannungsquelle des Netzteils 4 erzeugte Betriebs- oder Eingangsspannung Vₑ in Form beispielsweise einer Gleichspannung mit 24 V (DC) wird an den Spannungseingang 12 des Schutzschalters 2 angelegt.

Bei angeschlossenem Netzteil 4 und angeschlossener Last 6 fließt im Betrieb des Schutzschalters 2 ausgehend vom Spannungseingang 12 über den Strompfad 10 und somit über die Drain-Source-Strecke des Halbleiterschalters 8 sowie über die Last 6 ein Ausgangs- oder Laststrom I_{L} gegen Bezugspotential oder Ground GND ab. Die an der Last 6 abfallende Last- oder Ausgangsspannung Vₐ wird zwischen den Lastausgängen 14 und 16 mittels eines in den Schutzschalter 2 integrierten Spannungssensors 18 erfasst.

Der Halbleiterschalter 8 ist mittels eines Drainanschlusses 20 und eines Sourceanschlusses 22 in den Strompfad 10 verschaltet. Ein Gateanschluss 24 des Halbleiterschalters 8 ist ansteuerseitig an einen Controller 26 des Schutzschalters 2 geführt. Der beispielsweise als ein Mikrocontroller ausgeführte Controller 26 ist signaltechnisch an den Spannungssensor 18 gekoppelt. Während eines Normalbetriebs begrenzt der Controller 26 den Laststrom I_{L} beziehungsweise den durch den Halbleiterschalter 8 fließenden Source-Drain-Strom mittels einer Strombegrenzung auf einen Stromgrenzwert I_{g}, welcher beispielsweise gleich einem Nennwert I_{N} einem Nennstrom des Schutzschalters 2 ist.

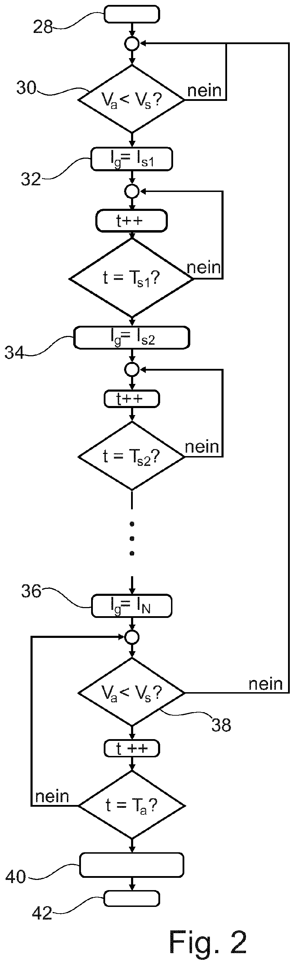

Ein Betriebsverfahren, welches sich insbesondere auch bei einem Einschalten des elektronischen Schutzschalters 2 auf eine kapazitive Last 6 oder bei einem Hinzuschalten einer kapazitiven Last 6 eignet, ist in dem in Fig. 2 gezeigten Flussdiagramm veranschaulicht. Nach einem Start 28, das bedeutet beispielsweise mit dem Einschalten des elektronischen Schutzschalters 2, erfolgt eine Abfrage beziehungsweise ein Schwellwertvergleich 30, ob die erfasste Ausgangsspannung Vₐ kleiner ist, als ein hinterlegter Spannungsschwellwert Vₛ.

Unterschreitet die Ausgangsspannung Vₐ den Spannungsschwellwert Vs, wird der Stromgrenzwert I_{g} in einem Verfahrensschritt 32 auf einen ersten Stufenwert Iₛ₁ erhöht. Der Stufenwert Iₛ₁ weist hierbei einen höheren Wert auf, als der ursprüngliche Nennwert I_{N}. Insbesondere ist der Stufenwert Iₛ₁ ein Vielfaches des Nennwerts I_{N}, also beispielsweise Iₛ₁ = a*I_{N}, wobei in einer möglichen Ausführung a = 3 ist. Die Strombegrenzung des Schutzschalters 2 wird anschließend für eine Stufenzeitdauer Tₛ₁ ausgeführt, das bedeutet, der Laststrom I_{L} wird für die Stufenzeitdauer Tₛ₁ auf den Stromgrenzwert I_{g} = Iₛ₁ begrenzt. Zu diesem Zwecke wird nach dem Verfahrensschritt 32 ein Timer oder Zeitmesser gestartet, welcher eine Zeit t erfasst und überwacht, ob die Zeit t die Stufenzeitdauer Tₛ₁ erreicht hat.

Nach der Stufenzeitdauer Tₛ₁ wird in einem Verfahrensschritt 34 der Stromgrenzwert auf einen zweiten Stufenwert Iₛ₂ erniedrigt. Der zweite Stufenwert Iₛ₂ ist hierbei kleiner als der vorangegangene Stufenwert Iₛ₁ und größer als der ursprüngliche Nennwert I_{N}. Insbesondere ist der Stufenwert Iₛ₂ ein Vielfaches des Nennwerts I_{N}, also beispielsweise Iₛ₂ = b*I_{N}, wobei in einer möglichen Ausführung zum Beispiel b = 2,65 ist. Anschließend wird erneut ein Timer gestartet, welcher abfrägt, ob die Zeit t die Stufenzeitdauer Tₛ₂ erreicht hat.

Der Stromgrenzwert I_{g} wird anschließend stufenweise sukzessive erniedrigt beziehungsweise reduziert, bis in einem Verfahrensschritt 36 der Stromgrenzwert I_{g} auf den ursprünglichen Nennwert I_{N}, also I_{g} = I_{N}, gesetzt wird. Hierbei wird in einem daran anschließenden Schwellwertvergleich 38 geprüft, ob die Ausgangsspannung Vₐ den Spannungsschwellwert Vₛ weiterhin oder erneut unterschreitet. Ist die Ausgangsspannung Vₐ kleiner als der Spannungsschwellwert Vₛ wird ein weiterer Timer für eine Auslösezeitdauer Tₐ gestartet. Während der Auslösezeitdauer Tₐ wird wiederholt geprüft, ob die Ausgangsspannung Vₐ kleiner als der Spannungsschwellwert Vₛ ist.

Überschreitet die Ausgangsspannung Vₐ während der Auslösezeitdauer Tₐ nicht den Spannungsschwellwert Vₛ, wird der Schutzschalter 2 in einem Verfahrensschritt 40 ausgelöst. Hierzu wird der Halbleiterschalter 8 von dem Controller 26 geöffnet beziehungsweise sperrend geschaltet. Das Verfahren wird anschließend in einem Verfahrensschritt 42 beendet.

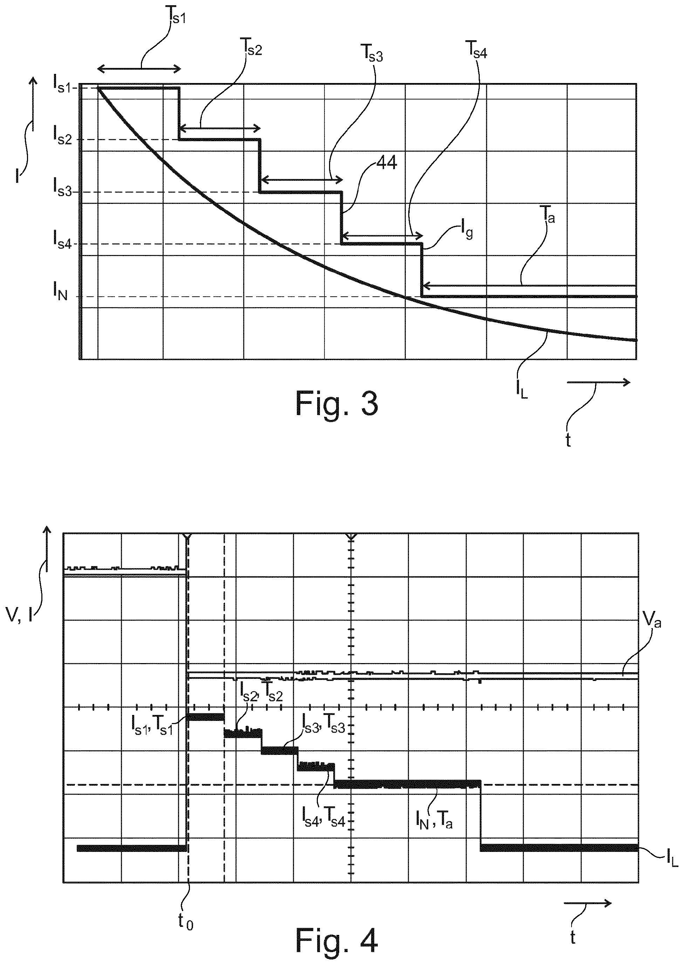

Anhand der Figuren 3 bis 6 ist nachfolgend die Wirkung des vorstehend beschriebenen Verfahrens näher erläutert.

Die Fig. 3 zeigt in einem Strom-Zeit-Diagramm einen schematischen Verlauf des Ladestroms I_{L} der kapazitiven Last 6 während eines Einschaltvorgangs mit einer stufenförmigen Strombegrenzung des Schutzschalters 2. Entlang der horizontalen Abszissenachse (x-Achse) ist hierbei die Zeit t aufgetragen. Entlang der vertikalen Ordinatenachse (y-Achse) ist der Strom I aufgetragen.

Die kapazitive Last 6 ist zum Einschalt- oder Zuschaltzeitpunkt ungeladen und kann somit eine Vielzahl an Elektronen aufnehmen. Dadurch ist der Widerstand der kapazitiven Last 6 beim Einschalten sehr gering, wodurch ein hoher Stromfluss auftritt, welcher vergleichbar mit einem Kurzschlussstrom ist. Durch die starke Strombelastung kommt es zu einem Einbruch der Ausgangsspannung Vₐ des Schutzschalters 2. Dadurch unterschreitet die Ausgangsspannung Vₐ im Verfahrensschritt 30 den Spannungsschwellwert Vₛ, sodass die Strombegrenzung mittels des Stromgrenzwertes I_{g} auf den Stufenwert Iₛ₁ erhöht wird.

Der Stromgrenzwert I_{g} wird in diesem Ausführungsbeispiel nach der Stufenzeitdauer Tₛ₁ stufen- beziehungsweise schrittweise auf einen Stufenwert Iₛ₂ für eine Stufenzeitdauer Tₛ₂ und auf einen Stufenwert Iₛ₃ für eine Stufenzeitdauer Tₛ₃ sowie auf einen Stufenwert Iₛ₄ für eine Stufenzeitdauer Tₛ₄ erniedrigt beziehungsweise reduziert. Nach der Stufenzeitdauer Tₛ₄ wird der Stromgrenzwert I_{g} abschließend auf den Nennwert I_{N} gesetzt. Der ursprüngliche Nennwert I_{N} wird anschließend für die Auslösezeitdauer Tₐ beibehalten. Die somit stufenförmige Strombegrenzung 44 bildet im Wesentlichen - wie in Fig. 3 vergleichsweise deutlich ersichtlich - eine Hüllkurve über den eigentlichen Stromverlauf des Laststroms I_{L} beim Einschalten oder Hinzuschalten der kapazitiven Last 6 ab. In dieser Ausführungsform sind die Stufenzeitdauern Tₛ₁, Tₛ₂, Tₛ₃ und Tₛ₄ vorzugsweise alle gleich lang bemessen.

Das Ausführungsbeispiel der Fig. 4 zeigt in einem Strom-/Spannungs-Zeit-Diagramm einen Verlauf des Ladestroms I_{L} der kapazitiven Last 6 und einen Verlauf der Ausgangsspannung Vₐ in einem Fehlerfall. Entlang der horizontalen Abszissenachse (x-Achse) ist hierbei die Zeit t aufgetragen. Entlang der vertikalen Ordinatenachse (y-Achse) ist der Strom I beziehungsweise die Spannung U aufgetragen.

In diesem Ausführungsbeispiel weist der Schutzschalter einen Nennstrom von etwa 2 A (Ampère) auf. Zu einem Zeitpunkt to wird der Schutzschalter 2 mit einem Strom I von etwa 8 A belastet. Dies bewirkt einen Einbruch der Ausgangsspannung Vₐ. In der Folge wird der Stromgrenzwert I_{g} für die Stufendauer Tₛ₁ auf den Stufenwert Iₛ₁ gesetzt. Der erste Stufenwert Iₛ₁ weist in diesem Ausführungsbeispiel einen Wert von 6 A auf. In dem Ausführungsbeispiel wird der Stromschalter 2 dauerhaft mit den 8 A belastet, sodass die Strombegrenzung auf den Stufenwert Iₛ₁ nicht ausreichend ist, um die Ausgangsspannung Vₐ wieder zu erhöhen. Nach der Stufenzeitdauer Tₛ₁, welche beispielsweise auf 122 ms dimensioniert ist, wird der Stromgrenzwert I_{g} auf den Stufenwert Iₛ₂ von etwa 5,3 A reduziert. Anschließend wird der Stromgrenzwert auf den Stufenwert Iₛ₃ von etwa 4,5 A und den Stufenwert Iₛ₄ von etwa 3,7 A stufenweise auf den Nennwert I_{N} reduziert, welcher in diesem Ausführungsbeispiel auf 2,8 A dimensioniert ist. Der Nennwert I_{N} wird während der Auslösezeitdauer Tₐ von etwa 500 ms beibehalten und überprüft, ob die Ausgangsspannung Vₐ den Spannungsschwellwert Vₛ weiterhin unterschreitet. Da die Ausgangsspannung Vₐ nach der Auslösezeitdauer Tₐ weiterhin eingebrochen ist, löst der Schutzschalter 2 anschließend aus.

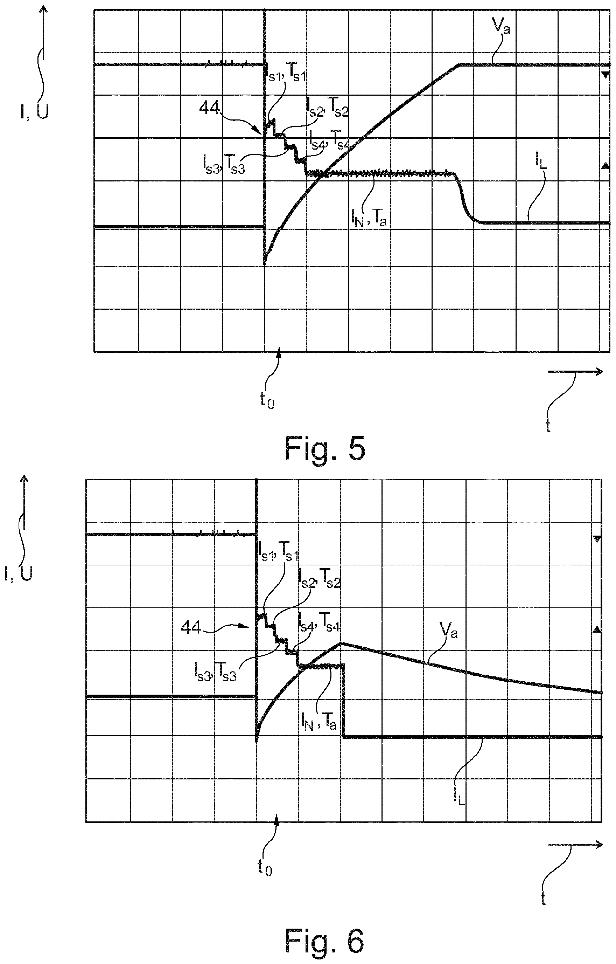

In dem Ausführungsbeispiel der Fig. 5 ist in einem Strom-/Spannungs-Zeit-Diagramm ein Verlauf des Ladestroms I_{L} der kapazitiven Last 6 und ein Verlauf der Ausgangsspannung Vₐ bei einem Hinzuschalten der kapazitiven Last 6 gezeigt.

In dem Ausführungsbeispiel der Fig. 5 weist der Schutzschalter 2 einen Nennwert von 4 A auf und wird mit einer Grundlast von etwa 2,4 A belastet. Zu dem Zeitpunkt to wird eine Kapazität von 43000 µF als Last 6 hinzugeschalten. Die Ausgangsspannung Vₐ bricht zunächst zusammen, wodurch die stufenförmige Strombegrenzung 44 eingeleitet wird. Da die Ausgangsspannung Vₐ innerhalb der Auslösezeitdauer Tₐ wieder ausreichend aufgebaut wird, und somit den Spannungsschwellwert Vₛ überschreitet, löst der Schutzschalter 2 nicht aus, sodass die Last 6 hinzugeschalten wurde, ohne dass dadurch andere Lasten im Stromkreis abgeschaltet oder in einen passivierten Zustand versetzt wurden.

In dem Ausführungsbeispiel der Fig. 6 ist die Auslösezeitdauer Tₐ etwa gleich zu der Zeitdauer der stufenförmigen Strombegrenzung 44. In dieser Ausführung weist der Schutzschalter 2 einen Nennwert von 3 A auf und wird mit einer Grundlast von etwa 2,4 A belastet. Zu dem Zeitpunkt to wird eine Kapazität von 43000 µF als Last 6 hinzugeschalten. Die Ausgangsspannung Vₐ bricht zunächst zusammen, wodurch die stufenförmige Strombegrenzung 44 eingeleitet wird. Da während der Auslösezeitdauer Tₐ die Ausgangsspannung Vₐ nicht wieder ausreichend aufgebaut wird, und dadurch den Spannungsschwellwert Vₛ nicht überschreitet, löst der Schutzschalter 2 aus.

### Bezugszeichenliste

- 2: Schutzschalter
- 4: Netzteil
- 6: Last
- 8: Halbleiterschalter
- 10: Strompfad/Pluspfad
- 12: Spannungseingang
- 14: Lastanschluss/Lastausgang
- 16: Lastanschluss
- 18: Spannungssensor
- 20: Drainanschluss
- 22: Sourceanschluss
- 24: Gateanschluss
- 26: Controller
- 28: Start
- 30: Schwellwertvergleich
- 32, 34, 36: Verfahrensschritt
- 38: Schwellwertvergleich
- 40, 42: Verfahrensschritt
- 44: Strom begrenzung

- GND: Ground
- Vₑ: Eingangsspannung
- I_{L}: Laststrom
- Vₐ: Ausgangsspannung
- Vₛ: Spannungsschwellwert
- I_{N}: Nennwert
- I_{g}: Stromgrenzwert
- Iₛ₁, Iₛ₂, Iₛ₃, Iₛ₄: Stufenwert
- Tₛ₁, Tₛ₂, Tₛ₃, Tₛ₄: Stufenzeitdauer
- t: Zeit
- Tₐ: Auslösezeitdauer
- I: Strom
- U: Spannung
- t₀: Zeitpunkt

## Patentansprüche

1. Verfahren zum Betreiben eines elektronischen Schutzschalters (2) mit einem zwischen einen Spannungseingang (12) und einen Lastausgang (14) geschalteten Halbleiterschalter (8), der beim Einschalten und/oder beim Zuschalten einer kapazitive Last (6) in Abhängigkeit von der am Lastausgang (14) erfassten Ausgangsspannung (Vₐ) angesteuert wird,
- wobei die Ausgangsspannung (Vₐ) mit einem hinterlegten Spannungsschwellwert (Vₛ) verglichen wird,
- wobei bei einem Erreichen oder Unterschreiten des Spannungsschwellwerts (Vₛ) ein Stromgrenzwert (I_{g}), auf welchen ein vom Halbleiterschalter (8) geführter Laststrom (I_{L}) begrenzt wird, von einem Nennwert (I_{N}) auf einen gegenüber diesem erhöhten ersten Stufenwert (Iₛ₁) eingestellt wird,
- wobei der Stromgrenzwert (I_{g}) von dem ersten Stufenwert (Iₛ₁) stufenweise auf den ursprünglichen Nennwert (I_{N}) reduziert wird,
- wobei mindestens ein zweiter Stufenwert (Iₛ₂, Iₛ₃, Iₛ₄) zwischen dem ersten Stufenwert (Iₛ₁) und dem Nennwert (I_{N}) vorgesehen ist, auf welchen der Stromgrenzwert (I_{g}) bei der stufenweisen Reduzierung eingestellt wird, und
- wobei der Halbleiterschalter (8) geöffnet wird, wenn die Ausgangsspannung (Vₐ) während einer Auslösezeitdauer (Tₐ) nach der stufenweisen Reduzierung des Stromgrenzwertes (I_{g}) den Spannungsschwellwert (Vₛ) nicht erreicht.

2. Verfahren nach Anspruch 1,
**dadurch gekennzeichnet,**
**dass** der Stromgrenzwert (I_{g}) nach einer jeweiligen Stufenzeitdauer (Tₛ₁, Tₛ₂, Tₛ₃, Tₛ₄) auf den nächstfolgenden Wert (Iₛ₂, Iₛ₃, Iₛ₄, I_{N}) reduziert wird.

3. Verfahren nach Anspruch 2,
**gekennzeichnet durch**
gleichlange Stufenzeitdauern (Tₛ₁, Tₛ₂, Tₛ₃, Tₛ₄) der einzelnen Stufenwerte (Iₛ₁, Iₛ₂, Iₛ₃, Iₛ₄).

4. Verfahren nach Anspruch 2 oder 3,
**gekennzeichnet durch**
eine Auslösezeitdauer (Tₐ), die gleich der Summe der einzelnen Stufenzeitdauern (Tₛ₁, Tₛ₂, Tₛ₃, Tₛ₄) ist.

5. Verfahren nach einem der Ansprüche 1 bis 4,
**dadurch gekennzeichnet,**
**dass** der Stromgrenzwert (I_{g}) auf einen ersten Stufenwert (Iₛ₁) erhöht wird, welcher gleich einem Vielfachen, insbesondere einem Dreifachen, des Nennwerts (I_{N}) ist.

6. Elektronischer Schutzschalter (2) mit einem Controller (26) und mit einem Halbleiterschalter (8), welcher zwischen einem Spannungseingang (12) und einem Lastausgang (14) geschaltet sowie steuerseitig an den Controller (26) geführt ist, welcher zur Durchführung des Verfahrens gemäß einem der Ansprüche 1 bis 5 vorgesehen und eingerichtet ist.

## Claims

1. Method for operating an electronic circuit breaker (2) with a semiconductor switch (8), which is connected between a voltage input (12) and a load output (14) and is driven when a capacitive load (6) is switched on and/or when it is switched on as a function of the output voltage (Vₐ) detected at the load output (14),
- wherein the output voltage (Vₐ) is compared with a stored voltage threshold (Vs),
- wherein, when the voltage threshold value (Vₛ) is reached or fallen below, a current limit value (I_{g}), to which a load current (I_{L}) carried by the semiconductor switch (8) is limited, is set from a nominal value (I_{N}) to a first step value (Iₛ₁), which is higher than the nominal value,
- wherein the current limit value (I_{g}) is gradually reduced from the first step value (Iₛ₁) to the original nominal value (I_{N}),
- wherein at least a second step value (Iₛ₂, Iₛ₃, Iₛ₄) is provided between the first step value (Iₛ₁) and the nominal value (I_{N}), to which the current limit value (I_{g}) is set during the stepwise reduction, and
- wherein the semiconductor switch (8) is opened when the output voltage (Vₐ) does not reach the voltage threshold (Vₛ) during a triggering time period (Tₐ) after the stepwise reduction of the current limit (I_{g}).

2. Method according to claim 1,
**characterized in**
**that** the current limit value (I_{g}) is reduced to the next value (Iₛ₂, Iₛ₃, Iₛ₄, I_{N}) after a respective step time period (Tₛ₁, Tₛ₂, Tₛ₃, Tₛ₄).

3. Method according to claim 2,
**characterized by**
equal step time periods (Tₛ₁, Tₛ₂, Tₛ₃, Tₛ₄) of the individual step values (Iₛ₁, Iₛ₂, Iₛ₃, Iₛ₄).

4. Method according to claim 2 or 3,
**characterized by**
a triggering time period (Tₐ) equal to the sum of the individual step time periods (Tₛ₁, Tₛ₂, Tₛ₃, Tₛ₄).

5. Method according to one of claims 1 to 4,
**characterized in**
**that** the current limit value (I_{g}) is increased to a first step value (Iₛ₁), which is equal to a multiple, in particular a triple, of the nominal value (I_{N}).

6. Electronic circuit breaker (2) with a controller (26) and with a semiconductor switch (8), which is connected between a voltage input (12) and a load output (14) and is routed on the control side to the controller (26), which is provided and equipped for carrying out the method according to one of claims 1 to 5.

## Revendications

1. Procédé pour faire fonctionner un disjoncteur électronique (2) avec un commutateur à semi-conducteur (8) monté entre une entrée de tension (12) et une sortie de charge (14), qui est commandé lors de la mise en circuit et/ou de la mise en circuit d'une charge capacitive (6) en fonction de la tension de sortie (Vₐ) détectée à la sortie de charge (14),
- dans lequel la tension de sortie (Vₐ) est comparée à une valeur seuil de tension mémorisée (Vₛ),
- dans lequel, lorsque la valeur seuil de tension (Vₛ) est atteinte ou n'est pas atteinte, une valeur limite de courant (I_{g}), à laquelle un courant de charge (I_{L}) conduit par le commutateur à semi-conducteurs (8) est limité, est réglée d'une valeur nominale (I_{N}) à une première valeur d'échelon (Iₛ₁) augmentée par rapport à celle-ci,
- dans lequel la valeur limite de courant (I_{g}) est réduite par paliers de la première valeur d'échelon (Iₛ₁) à la valeur nominale initiale (I_{N}),
- dans lequel il est prévu au moins une deuxième valeur d'échelon (Iₛ₂, Iₛ₃, Iₛ₄) entre la première valeur d'échelon (Iₛ₁) et la valeur nominale (I_{N}), à laquelle la valeur limite de courant (I_{g}) est réglée lors de la réduction par palier, et
- dans lequel le commutateur à semi-conducteurs (8) est ouvert lorsque la tension de sortie (Vₐ) n'atteint pas la valeur de seuil de tension (Vₛ) pendant une durée de déclenchement (Tₐ) après la réduction par étapes de la valeur limite de courant (I_{g}).

2. Procédé selon la revendication 1,
**caractérisé en ce**
**que** la valeur limite de courant (I_{g}) est réduite après une période de temps d'étage respective (Tₛ₁, Tₛ₂, Tₛ₃, Tₛ₄) à la valeur suivante (Iₛ₂, Iₛ₃, Iₛ₄, I_{N}).

3. Procédé selon la revendication 2,
**caractérisé par**
des périodes de temps d'étage de même longueur (Tₛ₁, Tₛ₂, Tₛ₃, Tₛ₄) des différentes valeurs d'échelon (Iₛ₁, Iₛ₂, Iₛ₃, Iₛ₄).

4. Procédé selon la revendication 2 ou 3,
**caractérisé par**
une période de temps de déclenchement (Tₐ), qui est égale à la somme des périodes de temps des étapes individuelles (Tₛ₁, Tₛ₂, Tₛ₃, Tₛ₄).

5. Procédé selon l'une des revendications 1 à 4,
**caractérisé en ce**
**que** la valeur limite de courant (I_{g}) est augmentée à une première valeur d'échelon (Iₛ₁), qui est égale à un multiple, en particulier à un triple, de la valeur nominale (I_{N}).

6. Disjoncteur électronique (2) avec un contrôleur (26) et avec un commutateur à semi-conducteur (8), qui est monté entre une entrée de tension (12) et une sortie de charge (14) et qui est guidé côté commande vers le contrôleur (26), lequel est prévu et configuré pour la mise en oeuvre du procédé selon l'une des revendications 1 à 5.
